# EUROPEAN PATENT APPLICATION

(11) **EP 0 685 893 A1**
(43) Date of publication of application: **06.12.1995**
(21) Application number: 95902936.4
(22) Date of filing: 09.12.1994
(51) Int. Cl.: H01L 35/32, G01K 7/02

(54) **THERMOELECTRIC CONVERSION ELEMENT, THERMOELECTRIC CONVERSION ELEMENT ARRAY, AND THERMAL DISPLACEMENT CONVERTER**

(30) Priority: 16.12.1993 JP 316663/93; 12.07.1994 JP 160077/94; 23.08.1994 JP 198386/94
(71) Applicant: MITSUBISHI MATERIALS CORPORATION, Chiyoda-ku, Tokyo 100 (JP)
(72) Inventor: IIZUKA, H., Denshigijutsu-Kenkyusho, Mitsubishi, Chichibu-gun, Saitama-ken 368 (JP); YAMAZAKI, T., Denshigijutsu-Kenkyusho, Mitsubishi, Chichibu-gun, Saitama-ken 368 (JP)
(74) Representative: KUHNEN, WACKER & PARTNER
(86) International application number: JP9402076
(87) International publication number: WO9517020

(57) **Abstract**

A thermoelectric conversion element with improved resistance to oxidation and thermal shocks, which is easily electroplated to form its electrodes. Insulating members (26) are formed on the opposite surfaces of a body made by joining P- and N-type semiconductors, and the members (26) are used as masks at the time of the plating work.

## Description

### Technical field

The present invention relates to a thermoelectric element comprising a P-type semiconductor and an N-type semiconductor, a thermoelectric element array of a plurality of electrically connected thermoelectric elements and a thermal displacement converter which is displaced in proportion to a temperature.

### Background Art

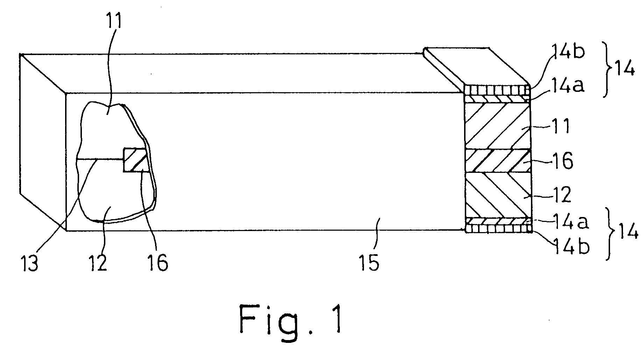

A hitherto known thermoelectric element comprising a P-type semiconductor and an N-type semiconductor will now be explained with reference to Fig. 1.

Fig. 1 is a partially cutaway section view illustrative of the state of the thermoelectric element in a plating step in the course of preparation of a thermoelectric element of the prior art.

On surfaces at end sides of the P-type semiconductor and the N-type semiconductor, there are formed electrodes 14 which conduct a voltage developed by heating a P-N junction 13 to an external voltmeter, etc. These electrodes 14 comprise a nickel plating film 14a and a solder plating film 14b, and these plating films 14a and 14b are formed by electroplating. During the formation of these plating films, in order not to form unnecessary plating films on the surfaces of the P-type semiconductor 11 and the N-type semiconductor 12, the surfaces other than the surfaces intended for the formation of the plating films 14a and 14b thereon are covered with a masking material 15, and a resin, rubber, tape, resist agent or the like is used as the masking material. Here, the P-type semiconductor 11 and the N-type semiconductor 12 are isolated from each other by an insulating material 16 except at the P-N junction.

In this connection, in cases where the above-mentioned resin or the like is used as the masking material, there has presented the problem of much expense in time and effort for the operations since each thermoelectric element must be subjected to a masking operation, and the masking material must be peeled off after completion of the plating.

In addition, since the use environment of thermoelectric elements is in a flame or at increased temperatures, there is the problem that thermoelectric elements readily undergo surface oxidation, suffer from deterioration in durability and characteristics, and the durability is severely impaired due to great thermal impacts.

In view of the above-mentioned circumstances, it is a first object of the present invention to provide a thermoelectric element which is prepared through a simple plating operation for the formation of the electrodes and has an improved oxidation resistance and durability against thermal impacts.

Incidentally, iron silicide-based laminar thermoelectric elements are laminates of alternating p-type iron silicide-based semiconductors and n-type iron silicide-based semiconductors, prepared in such a manner that junctions between the p-type iron silicide-based semiconductors and the n-type iron silicide-based semiconductors (hereunder sometimes referred to as "p-n junction") are formed at the laminar interfaces.

Among such iron silicide-based laminar thermoelectric elements, iron silicide-based laminar thermoelectric elements having one pair of p-n junctions are usually prepared by powder metallurgical procedures, wherein establishment of insulation is ensured by spacing in the regions of the laminar interface other than the p-n junction. In addition, in iron silicide-based laminar thermoelectric elements having a plurality of p-n junctions, sheets of forsterite or an organic substance which sublimates or evaporates upon baking are used as the insulating layers which constitute the regions of the junction interfaces other than the p-n junctions (Japanese Unexamined Patent Application Disclosure SHO 56-152282).

On the other hand, in the case of preparation of laminar thermoelectric elements using an oxide-based thermoelectric semiconductor material as the semiconductor material, insulator ceramics (Japanese Unexamined Patent Application Disclosure HEI 1-183863), resins (Japanese Unexamined Patent Application Disclosure HEI 1-194479) or glass (Japanese Unexamined Patent Application Disclosure HEI 1-262678) is employed as the insulating material of the insulating layers.

Here, these thermoelectric elements are prepared by baking a green sheet of a p-type semiconductor and a green sheet of an n-type semiconductor, with an intervening sheet of an insulating material (e.g., a green sheet of an insulator ceramic in cases where the insulating material is an insulator ceramic) placed at sections other than the section for the formation of the p-n junction.

Among the iron silicide-based laminar thermoelectric elements of the prior art, those with a configuration which maintains insulating properties by spacing have the drawback that those thermoelectric elements have low resistance to impacts from the outside when, for example, they are dropped.

Accordingly, it is desired that the laminar interfaces other than the p-n junctions should have a structure comprising an insulating layer made of an insulating material from the point of view of ensuring the mechanical strength of the thermoelectric elements. However, use of an insulator ceramic as the insulating material results in cracking and delamination in the interfaces of the semiconductor and insulating layer, during sintering, which are attributable to difference in the thermal expansion coefficient or contraction coefficient of the semiconductor and the insulator ceramic. On the other hand, use of a resin or glass as the insulating material results in to lower thermal stability, thus presenting the problem of poor durability when the use of thermoelectric elements at increased temperatures for a long time is considered.

It is a second object of the present invention to solve the above-mentioned problems of the prior art and to provide a thermoelectric element which is provided with insulating layers at the laminar interfaces other than the p-n junctions, which is free from the problem of cracking and delamination, and which has excellent thermal stability and durability.

Common thermoelectric elements of the prior art are made by joining a block of p-type semiconductors and a block of n-type semiconductors via a metal (π-type junction). When the junctions (higher-temperature ends) are heated, an electromotive force is produced due to the Seebeck effect, based on the difference in temperature between the higher-temperature ends and the opposite ends of the semiconductors (lower-temperature ends). For example, in cases where the compositions of the semiconductors are based on FeSi₂, there have been manufactured elements which produce an electromotive force of 0.3 V for a difference in temperature of 600°C.

In cases where the electromotive force obtained with a set (a pair) of a p-type semiconductor and an n-type semiconductor is too small, several to several dozens of pairs of them are connected in series to obtain a desired level of electromotive force. For example, in cases where five of the above-mentioned elements, each generating an electromotive force of 0.3 V, are connected in series and each element undergoes a difference in temperature of 600°C, a total electromotive force of 1.5 V is obtained.

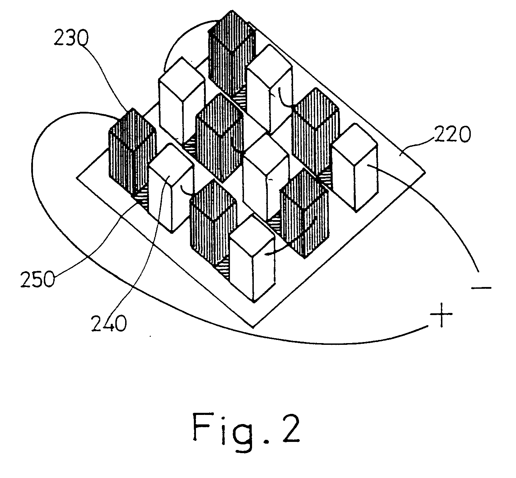

In cases where a heat source is flat and has some area, a thermoelectric element array, which produces a greater electromotive force than the one-pair elements, can be manufactured by connecting a plurality of thermoelectric elements electrically in series, with their higher-temperature ends arranged in one plane, as shown in Fig. 2, and thus the thermal energy can be converted into electric energy.

In order to obtain greater electromotive forces, however, it was necessary to increase the number of pairs of p-type semiconductors and n-type semiconductors with the result that the space for placement of the p-type semiconductors, the n-type semiconductors and metal materials for joining them was enlarged, inevitably to increase the area of the thermoelectric element array . Although narrowing of each semiconductor results in space savings, it also results in difficult assembly and wiring, and further since the connection is in series, there has existed the problem that a failure of even one of the semiconductors leads to the loss of the electromotive force of the entire thermoelectric element array.

In view of the above-mentioned circumstances, it is a third object of the present invention to provide a thermoelectric element array of a reduced area which provides a greater electromotive force and is easy to assemble.

In order to produce greater output, thermoelectric element arrays of the prior art are constructed in such a manner that a plurality of p-type thermoelectric elements and n-type thermoelectric elements are connected alternately. In other words, the minimum unit of such thermoelectric element arrays is a pair of one p-type thermoelectric element and one n-type thermoelectric element connected in series. According to the prior art, these pairs are further connected in series or in parallel into modules so that the modules produce higher voltages or higher outputs collectively.

According to modules of the prior art, since the p-type thermoelectric elements and the n-type thermoelectric elements are constructed separately, in order to manufacture fifty pairs of the modules, for example, fifty each of the p-type thermoelectric elements and the n-type semiconductors, or a total of a hundred thermoelectric elements are needed. In addition, wiring is needed for electrical connection between both ends of these thermoelectric elements.

Accordingly, for the manufacture of such thermoelectric element arrays exact positioning of many p-type semiconductors and n-type semiconductors is necessary from the points of view not only of electrical connection, but also of spatial arrangement. Hitherto, applications for patent have been filed regarding improvements to such arrangement operations, as disclosed in Japanese Unexamined Patent Application Disclosure HEI 3-225973, Japanese Unexamined Patent Application Disclosure HEI 4-299585, etc.

On the other hand, Japanese Unexamined Patent Application Disclosure HEI 5-316663 indicates that use of a laminar thermoelectric element results in fundamental space savings. This laminar thermoelectric element is a laminate of alternating p-type semiconductors and n-type semiconductors which has direct junctions between p-type semiconductors and n-type semiconductors at the laminar interfaces, with the region of the laminar interfaces other than the junctions being insulated with insulating ceramic layers, and which results in space savings since no connection space is needed between the p-type thermoelectric elements and the n-type thermoelectric elements.

Even in cases where such laminar thermoelectric elements are used, however, since preparation of a thermoelectric element array through connection of a plurality thereof requires connections between terminal electrodes of the laminar thermoelectric elements using conductor wires, a space is necessary for wiring between the terminal electrodes. Accordingly, even though the laminar thermoelectric elements are effective for saving space, the space for wiring cannot be eliminated and thus the space savings are limited. In addition, basically the wiring between the terminal electrodes does not result in the desired configuration since the wiring may cause increase in resistance and disconnection.

Even in cases where a printed board with the wiring formed thereon is used in order to avoid much expense in time and effort for the wiring, since thermoelectric elements must be exactly positioned on the pattern of the printed board, the assembly is not easy to complete. In this case, since rectangular, laminar thermoelectric elements are placed upright and assembled on the board, the assembly becomes harder as their number increase and their packing density becomes higher.

It is a fourth object of the present invention to overcome the problems of the prior art and to provide a thermoelectric element array which does not need wiring between the thermoelectric elements, is free from the problem of increased resistance and disconnection due to the wiring, permits easy assembly and results in space savings.

Among those which are displaced in accordance with temperatures, the simplest type includes bimetals used in thermostats. In addition, in cases where precise displacement in accordance with temperatures is needed, an apparatus is conceivable which is a combination of a temperature detection unit composed with a thermistor or a thermo-couple and an electromagnetic actuator or a piezoelectric actuator which is displaced in accordance with the voltage developed by the temperature detection unit.

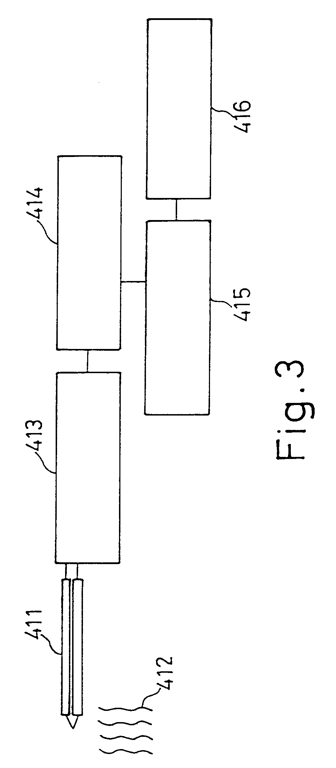

This apparatus will now be explained with reference to Fig. 3.

In cases where the thermo-couple 411 is heated by the heat from a heat source 412, the temperature measured with a thermometer 413 changes, and a signal representing the temperature measured with the thermometer 413 is outputted from an arithmetic circuit 414 (CPU). This signal is inputted to a direct-current power source 415, and the voltage corresponding to the signal is applied to an actuator 416, upon which the actuator 416 is displaced, and as a result, a displacement corresponding to the heated temperature of the thermo-couple 411 is accomplished.

Bimetals have both the function of detecting temperatures and the displacement function of being displaced in accordance with the temperatures, and are placed themselves in environments which undergo temperature changes. For this reason, it is impossible, for example, to place only the displacement section which performs the displacement function, apart from the temperature detection section which performs the temperature detection function, and this results in a low degree of design flexibility.

In addition, the above-mentioned apparatus equipped with the thermo-couple 411 and the actuator 416 needs the arithmetic circuit 414 (CPU) which converts the information from the thermo-couple 411 to a temperature and send a command determined by the temperature to the direct-current power source 415. Although this apparatus has an advantage in that making modifications of the program for the arithmetic circuit 414 allows flexible response to a variety of cases, and an additional advantage in that use of an piezoelectric actuator results in less power consumed as compared with the use of an electromagnetic motor, etc., due to the high insulation resistance of the piezoelectric actuator, it also presents the problems of complicated, high-cost configuration of the apparatus and difficult miniaturization.

On the other hand, various attempts have been made to manufacture units for running electromagnetic motors and for opening and closing electromagnetic valves using thermoelectric elements as driving sources. However, since these electromagnetic actuators essentially need more power as compared with piezoelectric actuators, it is difficult to drive the electromagnetic actuators with the output (several dozen mW) of a common thermoelectric element, and thus they have not been used widely in practice.

In view of the above-described circumstances, it is a fifth object of the present invention to provide a thermal displacement converter which has a simpler configuration as compared with the prior art and allows displacement proportional to the temperature.

### Disclosure of the Invention

A first thermoelectric element of the present invention to accomplish the above-mentioned first object comprises a P-type semiconductor and an N-type semiconductor placed facing each other, with a P-N junction at one end thereof; a first insulator which is formed between the facing surfaces of the above-mentioned P-type semiconductor and the above-mentioned N-type semiconductor to insulate the above-mentioned P-type semiconductor and the above-mentioned N-type semiconductor from each other; and second insulating materials formed on the respective surfaces opposite the facing surfaces, and is characterized in that the above-mentioned P-type semiconductor, the above-mentioned N-type semiconductor, the above-mentioned first insulator and the above-mentioned second insulating materials are integrally baked.

A second thermoelectric element of the present invention to accomplish the above-mentioned first object comprises a plurality of P-type semiconductors and a plurality of N-type semiconductors placed facing each other and alternately, with P-N junctions at either alternating end thereof; a first insulator which is formed between each of the facing surfaces of the above-mentioned P-type semiconductors and the above-mentioned N-type semiconductors to insulate the above-mentioned P-type semiconductors and the above-mentioned N-type semiconductors from each other; and second insulating materials formed on the respective surfaces opposite the facing surfaces of the outermost ones of the above-mentioned P-type semiconductors and the above-mentioned N-type semiconductors, and is characterized in that the above-mentioned P-type semiconductors, the above-mentioned N-type semiconductors, the above-mentioned first insulators and the above-mentioned second insulating materials are integrally baked.

Here, the above-mentioned insulating materials used are preferred to be insulating materials a main component of which is zirconia, magnesia, etc.

According to the first thermoelectric element of the present invention, the second insulating materials formed on the respective surfaces of the p-type semiconductor and the n-type semiconductor which are opposite to the facing surfaces thereof are baked together with the semiconductors. No plating layers by electroplating are precipitated on the second insulating materials. Therefore, no masking operation or masking material-peeling operation which is conducted for the formation of the electrodes by electroplating is needed, and thus the plating operation becomes simpler. Also, since the insulating materials are formed on the opposite surfaces, the oxidation resistance and the resistance to thermal impacts are increased.

Since the second thermoelectric element of the present invention is an equivalent of a plurality of the twin thermoelectric elements which are connected in series, it can produce a great thermal electromotive force.

In addition, the thermoelectric element to accomplish the above-mentioned second object of the present invention is a thermoelectric element which comprises a laminate of alternating p-type semiconductors and n-type semiconductors, with junctions formed at the above-mentioned laminar interfaces for establishing electric connections between the p-type semiconductors and the n-type semiconductors and with intervening insulating layers present in regions other than the junctions of the above-mentioned laminar interfaces, and which is characterized in that the above-mentioned insulating layers are a sintered material of a mixture comprising one or more insulator ceramics selected from the group consisting of zirconium oxide, aluminum oxide, magnesium oxide, titanium oxide and yttrium oxide, and glass, the content of the above-mentioned glass being 10-50% by weight.

Here, the glass contained in the mixed material preferably includes silicon oxide, boron oxide, aluminum oxide and an alkaline earth metal oxide.

Formation of the insulating layers using the mixed material comprising the above-specified insulator ceramic and glass results in decrease of the sintering temperature of the insulating layers including the insulator ceramic which sinter upon baking essentially at higher temperatures than the semiconductors, to approximately the sintering temperature of the semiconductors, thereby allowing the insulating layers to sinter with the semiconductors integrally. In addition, since the incorporation of the glass helps the thermal expansion coefficient of the insulating layers approach the thermal expansion coefficient of the semiconductor layers, cracking and delamination due to difference in thermal expansion coefficient is prevented.

Particularly, in the course of baking, the component glass migrates to the junction interfaces with the semiconductors and works as if it is an adhesive agent between the semiconductor layers and the insulator ceramics, and this also prevents delamination upon baking, at the interfaces between the semiconductor layers and the insulating layers.

In cases where the glass contained in the mixed material comprises silicon oxide, etc., there are provided thermoelectric elements which have more excellent thermal resistance and durability.

The thermoelectric element array of the present invention which accomplishes the above-mentioned third object is characterized in that the array comprises a plurality of electrically connected, laminar thermoelectric elements, each element comprising one or more laminated pairs of a P-type semiconductor and an N-type semiconductor, with a P-N junction at a higher-temperature end and an intervening insulating layer at a lower-temperature end thereof, and the elements are placed with the higher-temperature ends on an identical plane.

Since the above-mentioned thermoelectric element array of the present invention comprises the above-mentioned laminar thermoelectric element as the component thermoelectric element of the array, there is no need to provide additional metal connections on, for example, the aluminum board 220 shown in Fig. 2. In addition, the laminar thermoelectric element produces a greater electromotive force as the number of the pair increases. For example, one such element, which comprises six pairs of p-n (combination of a p-type thermoelectric semiconductor 230 and an n-type thermoelectric semiconductor 240) each placed on a metal material 250, has an electromotive force of 1.5 V for a temperature difference of 600°C.

As compared with the arrangement of many prior art elements connected in series on a plane as shown in Fig. 2, it is possible to manufacture an array which comprises a less number of elements, in other words, has a reduced area, but has a comparable electromotive force. On the other hand, an array of the same area has an electromotive force which is several to several dozens of times that of a prior art π-type junction element. In addition, since no metal junction is needed at the higher-temperature end between the p-type semiconductor and the n-type semiconductor, the arrangement has a high degree of flexibility.

The thermoelectric element array of the present invention to accomplish the above-mentioned fourth object is a thermoelectric element array which comprises a plurality of connected laminar thermoelectric elements, and which is characterized in that a terminal electrode formed on the outer surface of each of the above-mentioned laminar thermoelectric elements is directly connected with a terminal electrode formed on the outer surface of another of the above-mentioned laminar thermoelectric elements adjacent to the former laminar thermoelectric element to electrically connect the two laminar thermoelectric elements.

Since the above-mentioned thermoelectric element array of the present invention is designed in such a manner that the terminal electrodes of the laminar thermoelectric elements are directly connected to establish electric connections between the laminar thermoelectric elements, no wiring is needed between the terminal electrodes. For this, there is no possibility of increasing resistance due to wiring and wire breakage. In addition, since there is no need to have wiring space, more space can be saved.

Furthermore, since the laminar thermoelectric elements may be assembled lying horizontally, without being placed upright, the assembly operation of the thermoelectric element array becomes much easier, and thus the operating efficiency is increased.

The thermal displacement converter of the present invention to accomplish the above-mentioned fifth object is characterized by comprising a thermoelectric element which is formed of a thermoelectric material and develops a voltage proportional to the temperature, and a piezoelectric actuator which is displaced due to the voltage developed by the above-mentioned thermoelectric element and proportional to the above-mentioned voltage.

Here, the "thermoelectric material" means "material which comprises separate, highly electrically conductive P-type and N-type semiconductors joined at one end and branched at the other end, and which produces, upon heating of the junction, a Seebeck effect which causes generation of a current through the above-mentioned branching end, or, produces, upon feeding back a current through the above-mentioned branching end, a Peltier effect which causes absorption of heat by the junction".

With the thermal displacement converter of the present invention, the thermoelectric element formed of such a thermoelectric material develops a voltage in proportion to the temperature, and the piezoelectric actuator is displaced in accordance with the voltage. Since the thermoelectric element is used as the driving source for the piezoelectric actuator in this way, a thermistor, controller, power source, etc. are not needed to displace the piezoelectric actuator in proportion to the temperature, and thus there is provided a thermal displacement converter which has a simpler configuration as compared with the prior art.

### Brief Description of the Drawings

Fig. 1 is a partially cutaway section view illustrative of the state of the thermoelectric element in a plating step in the course of preparation of a thermoelectric element of the prior art.

Fig. 2 is a perspective view illustrative of a π-type junction thermoelectric element array of the prior art.

Fig. 3 is a schematic diagram illustrative of a thermal displacement converter of the prior art.

Fig. 4 is a section view illustrative of a thermoelectric element according to a first embodiment of the present invention.

Fig. 5 is a section view illustrative of a thermoelectric element according to a second embodiment of the present invention.

Fig. 6 is a perspective view illustrative of an embodiment of the thermoelectric element of the present invention.

Fig. 7 is a section view taken on line ②-② in Fig. 6.

Fig. 8 is an enlarged scheme of the section ③ in Fig. 7.

Fig. 9 is a perspective view which shows an example of one of the thermoelectric elements which constitute a thermoelectric element array of the present invention.

Fig. 10 is a perspective view illustrative of an embodiment of the thermoelectric element array of the present invention.

Fig. 11 is a perspective view illustrative of another embodiment of the thermoelectric element array of the present invention.

Fig. 12 is a perspective view of the laminar thermoelectric element used in the thermoelectric element array of Fig. 11.

Fig. 13 is a plan view of the main section of the thermoelectric element array of Fig. 11.

Fig. 14 is a perspective view illustrative of how the thermoelectric element array of Fig. 11 is assembled.

Fig. 15 is a schematic diagram illustrative of a thermal displacement converter, an embodiment of the present invention.

### Best Mode for Carrying Out the Invention

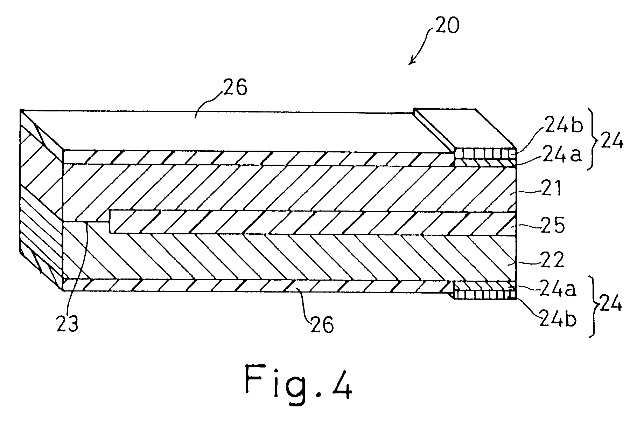

A thermoelectric element according to a first embodiment of the present invention will now be explained with reference to Fig. 4.

Fig. 4 is a section view illustrative of the thermoelectric element according to a first embodiment.

This thermoelectric element 20 comprises a P-type semiconductor 21 and an N-type semiconductor 22 placed opposite to each other, and electrodes 24 are formed on the surfaces of the P-type semiconductor 21 and the N-type semiconductor 22 at one of their ends, which serve to pass the current which is generated by heating a P-N junction 23, to an external ammeter, etc. These electrodes 24 are composed of a nickel plating film 24a and a solder plating film 24b, and these plating films 24a and 24b are formed by electroplating. In addition, the P-type semiconductor 21 and the N-type semiconductor 22 are separated by an insulating material 25, except at the P-N junction 23. Further, insulating materials 26 are formed on the surfaces of the P-type semiconductor and the N-type semiconductor which are opposite to their facing surfaces, except at the sections of the formed electrodes 24. Here, a p-FeSi₂ semiconductor and an n-FeSi₂ semiconductor are used as the materials for the P-type semiconductor 21 and the N-type semiconductor 22, respectively, and an insulating material comprising zirconia mixed with glass, is used as the material for the insulating material 25.

A method of manufacturing the thermoelectric element 20 will now be explained.

The above-mentioned P-FeSi₂ semiconductor, n-FeSi₂ semiconductor and insulating material are made into green sheets and laminated in the order: insulating material, p-FeSi₂ semiconductor, insulating material, n-FeSi₂ semiconductor and insulating material, and the laminate is subjected to thermo-compression bonding. During this process, the p-FeSi₂ semiconductor and the n-FeSi₂ semiconductor are joined at one of their ends to form the P-N junction 23. Here, it is formed in such a manner that no insulating material is formed at the other ends opposite the ends where the P-N junction 23 is formed. Thereafter, the laminate is cut into pieces of the shape shown in Fig. 4, and then degreased and baked. Here, an insulating material the main component of which is zirconia, magnesia, etc. is also used as the material for the insulating material 25, and thus the baking can be carried out integrally. The sintered product obtained in this way undergoes electroplating with nickel and solder in a barrel. Since the surfaces other than the surfaces at the ends opposite the ends of the formed P-N junction 23 are coated with an insulating material, no plating film is formed thereon, and as a result, electrodes 24 composed with plating layers are formed only at the opposite ends.

According to the present embodiment, since insulating materials the main component of which is zirconia, magnesia or the like are formed on the surfaces of the p-FeSi₂ semiconductor and n-FeSi₂ semiconductor by the integral baking process, as masking materials for the plating, no masking operation or masking material-peeling operation is needed, and thus the plating operation becomes simpler. Also, since insulating materials are formed on the surfaces of the p-FeSi₂ semiconductor and n-FeSi₂ semiconductor, the oxidation resistance and the resistance to thermal impacts are increased.

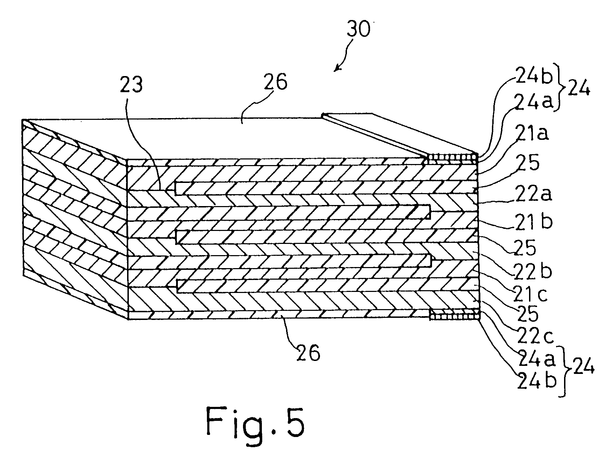

A thermoelectric element according to a second embodiment of the present invention will now be explained with reference to Fig. 5.

Fig. 5 is a section view illustrative of a thermoelectric element according to a second embodiment, wherein the same components as of the thermoelectric element 20 shown in Fig. 4 are indicted with the same reference characters.

The thermoelectric element 30 is composed of three P-type semiconductors 21a, 21b and 21c and three N-type semiconductors 22a, 22b and 22c which alternate and face each other, with P-N junctions 23 formed alternately at either end. In addition, an insulating material 26 is formed on the outer surface of each of the P-type semiconductor 21a and the N-type semiconductor 22c.

A method of manufacturing the thermoelectric element 30 will now be explained.

This thermoelectric element 30 is manufactured almost in the same manner as in the case of manufacture of the above-described thermoelectric element 20, by successively laminating an insulating material 26, an N-type semiconductor 22c, an insulating material 25, a P-type semiconductor 21c, an insulating material 25, an N-type semiconductor 22b, ······, a P-type semiconductor 21a and an insulating material 26, and then subjecting the laminate to thermo-compression bonding, cutting, degreasing and baking.

This thermoelectric element 30, an equivalent of three thermoelectric elements 20 according to the first embodiment connected in series, allows production of high levels of thermal electromotive force.

In this connection, an array of four or more each of the P-type semiconductors and the N-type semiconductors can be manufactured by almost the same method as the one described above.

As explained above, in the thermoelectric element according to the above-described embodiment, since the insulating materials are formed on the surfaces opposite the facing surfaces of the facing P-type semiconductors and N-type semiconductors, the masking operation and masking material-peeling operation are omitted in the plating step, and further the thermoelectric element has excellent oxidation resistance and resistance to thermal impacts.

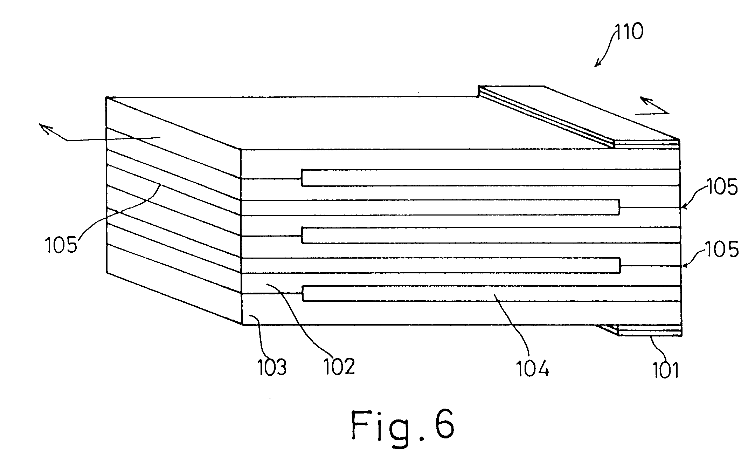

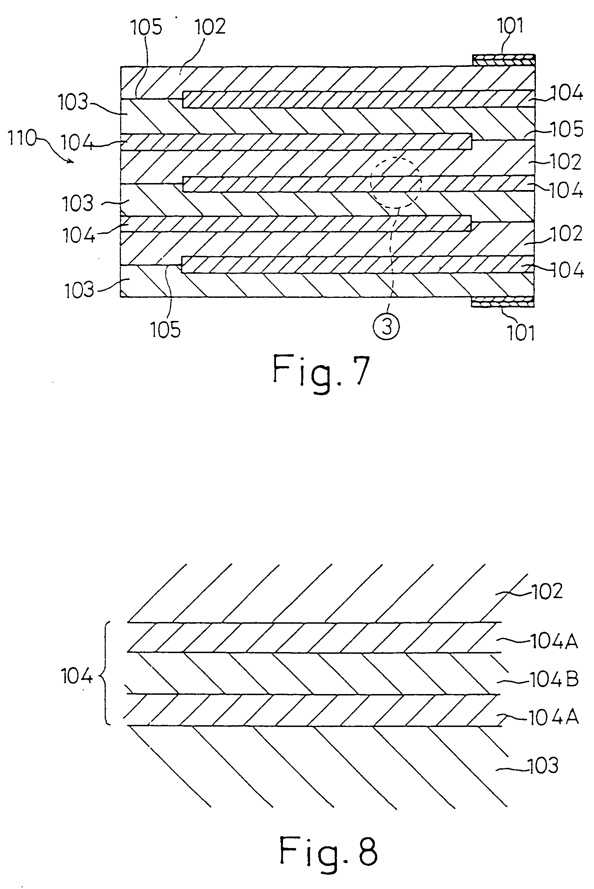

Fig. 6 is a perspective view illustrative of an embodiment of the thermoelectric element of the present invention, Fig. 7 is a section view taken on line ②-② in Fig. 6, and Fig. 8 is an enlarged scheme of the section ③ in Fig. 7.

The thermoelectric element according to the present embodiment is an iron silicide-based laminar thermoelectric element 110 comprising a laminate of a plurality of pairs of alternating p-type iron silicide-based semiconductors 102 and n-type iron silicide-based semiconductors 103, with p-n junctions formed at interfaces of the laminated p-type iron silicide-based semiconductors 102 and n-type iron silicide-based semiconductors 103. The p-n junctions 105 are alternately formed on either of the opposite edge sections of the iron silicide-based semiconductors 102 and 103. At the interfaces between the laminated p-type iron silicide-based semiconductors 102 and n-type iron silicide-based semiconductors 103, the regions other than the p-n junctions 105 are separated by insulating layers 104. Here, 101 indicates electrode sections.

According to the present invention, the insulating layers 104 are formed of a mixed material which comprises one or more insulator ceramics selected from the group consisting of zirconium oxide (ZrO₂), aluminum oxide (Al₂O₃), magnesium oxide (MgO), titanium oxide (TiO₂) and yttrium oxide (Y₂O₃) and glass at a glass content of 10-50% by weight.

Specifically, the thermoelectric element according to the present embodiment is manufactured by: mixing a powder of the above-specified insulator ceramic and a powder of glass to a glass powder content of 10-50% by weight; adding a binder, plasticizer, dispersing agent, solvent, etc. which are required for forming, to the mixture to prepare a forming material; making the forming material into sheets; laying the resulting green sheets between separately prepared green sheets of the p-type iron silicide-based semiconductor and the n-type iron silicide-based semiconductor; and baking thereof at 1180-1220°C.

In the course of this baking, the component glass in the insulating layers migrates to the junction interfaces with the semiconductors. For this, the insulating layers at the side of the junction interfaces with the semiconductors become glass-rich layers, whereas the center sections of the insulating layers in the direction of their thickness become insulator ceramic-rich layers, and thus, as shown in Fig. 8, there are provided insulator layers 104 with a roughly three-layer construction comprising an insulator ceramic layer 104B sandwiched between glass layers 104A and 104A. These glass layers 104A formed at the side of the junction interfaces with the semiconductors serve as an adhesive agent for the insulator ceramic layers 104B and the p-type iron silicide-based semiconductors 102 or the n-type iron silicide-based semiconductors 103 to moderate the difference in thermal expansion or contraction between the insulator ceramics and the semiconductors, thus preventing delamination. In addition, the insulator ceramic layers 104B increase the thermal resistance and thermal stability of the insulating layers 104.

According to the present invention, in cases where the glass content of the mixed material, which comprises an insulator ceramic and glass and forms the insulating layers, is less than 10% by weight, since the thicknesses of the glass layers which are formed at the side of the junction interfaces with the above-described semiconductors are reduced, and the effect of moderating the difference in thermal expansion or contraction between the semiconductors and the insulator ceramics is not satisfactory, delamination occurs in some cases upon baking. In cases where the glass content exceeds 50% by weight, the insulator layers have poor thermal stability, and the thermoelectric element cannot withstand use at increased temperatures for a long time.

Here, the glass used according to the present invention is preferably one comprising silicon oxide, boron oxide, aluminum oxide and an alkaline earth metal oxide. Since such SiO₂-B₂O₃-Al₂O₃ type glass has a high glass transition point and softening point, it is suitable for use at increased temperatures for a long time. Contrary, other types of glass, for example, glass of the SiO₂-PbO type, B₂O₃-PbO type, B₂O₃-PbO-ZnO type, etc. suffer from evaporation of the glass components when used for a long time, and the element is impaired.

The semiconductor material is preferred to be an iron silicide-based semiconductor material, but others including chromium silicide-based and manganese silicide-based semiconductor materials may be used as well.

Although Fig. 6 through Fig. 8 show a thermoelectric element comprising a plurality of pairs of p-n junctions, the present invention may also be applied to thermoelectric elements comprising one pair of p-n junctions.

The following is a more specific explanation of the present invention with reference to the Examples and Comparative examples.

### Example 1

The thermoelectric element of the present invention shown in Fig. 6 was manufactured.

FeSi₂ with 2 M % CrSi₂ added thereto was used as the p-type iron silicide-based semiconductor material, and FeSi₂ with 2 M % CoSi₂ added thereto was used as the n-type iron silicide-based semiconductor material. Further, ZrO₂ powder, to which 40% by weight of glass powder [composition (% by weight): SiO₂ = 60, B₂O₃ = 15, Al₂O₃ = 10, an alkaline earth metal oxide = 15] was added, was used as the insulating material. Polyvinyl butyral (PVB) as the binder, dibutyl phthalate as the plasticizer, ether type nonionic surfactant "GAFAC" (trade name of Toho Chemicals Co., Ltd.) as the dispersing agent and ethanol and toluene as the solvent were added to each of the above-mentioned three materials for slurrying, and the slurry was made into green sheets by a method using a doctor blade. These were laminated in the order: p-type iron silicide-based semiconductor sheet, insulating sheet, n-type iron silicide-based semiconductor sheet, insulating sheet, ..., insulating sheet and n-type iron silicide-based semiconductor sheet, with five p-n junctions formed alternately at either end, and then subjected to thermo-compression bonding. The resulting laminate was cut into elements of desired shapes which then underwent removal of the binder therefrom in a degreasing step in the air at 400°C for 2 hours, followed by a sintering step *in vacuo* at 1200°C for 4 hours and an annealing step in the air at 850°C for 50 hours and electrode sections were formed thereon, thus providing iron silicide-based laminar thermoelectric elements as shown in Figs. 6 and 7.

The insulating layers of the resulting iron silicide-based laminar thermoelectric elements have a structure as shown in Fig. 8, wherein the glass components have migrated to the sides of the interfaces with the semiconductor layers to form a glass layer between the ZrO₂ layer and the FeSi₂ layer, which structure prevented cracking and delamination upon baking, at the interfaces between the semiconductor layers and the insulating layers.

The thermal resistance of the obtained thermoelectric elements was tested by carrying out a continuous heating test at 850°C, with the results reported in Table 1 as assessments rated against a standard of "good" (o) for changes in the internal resistance within ±5%, and "poor" (x) for changes in the internal resistance exceeding ±5%.

### Examples 2-5 of the invention and Comparative examples 1 and 2

The same procedures as in Embodiment 1 were followed, except that those listed in Table 1 were used as the insulator ceramic powder, and glass powder was added thereto in the proportions indicated in Table 1 to form insulating layers, to manufacture thermoelectric elements which were examined for the presence or absence of cracking and delamination upon baking and for thermal resistance, with the results reported in Table 1.

**Table 1**

| Example Nos. | | Insulator ceramic | Glass content (wt%) | Cracking and delamination upon baking | Heat resistance* |
|---|---|---|---|---|---|
| Examples of the invention | 1 | ZrO₂ | 40 | No | O |
| | 2 | Al₂O₃ | 40 | No | O |
| | 3 | MgO | 10 | No | O |
| | 4 | TiO₂ | 20 | No | O |
| | 5 | Y₂O₃ | 50 | No | O |
| Comparative examples | 1 | ZrO₂ | 5 | Yes | O |
| | 2 | ZrO₂ | 60 | No | x |

| | | | | | |
|---|---|---|---|---|---|
| * O: Good | | | | | |
| x: Poor | | | | | |

As detailed above, the thermoelectric elements of the present invention have no problems of cracking and delamination upon baking, at the interfaces between the semiconductor layers and the insulating layers, and further the insulating layers have excellent thermal resistance and thermal stability. Accordingly, the present invention allows substantial increase in reliability, durability and yields of thermoelectric elements. In addition, in cases where the glass in the mixed material contains silicon oxide, etc., there are provided thermoelectric elements having even more excellent thermal resistance and durability.

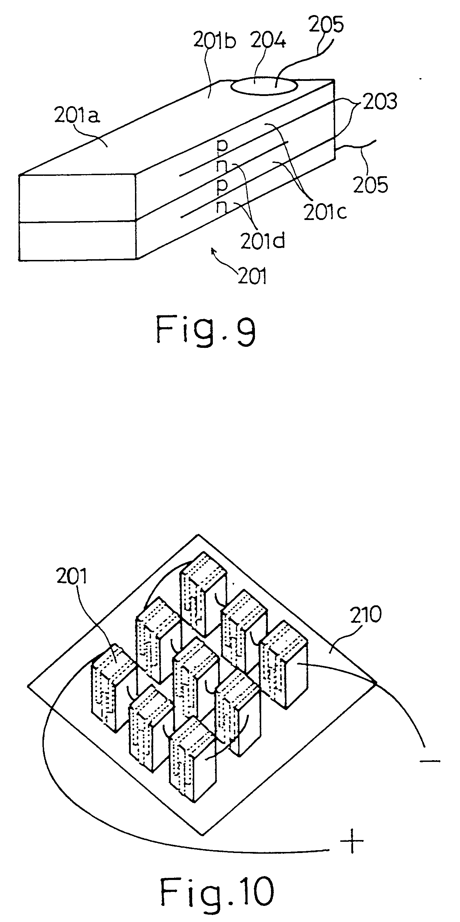

Fig. 9 is a perspective view which shows an example of one of the thermoelectric elements which constitute a thermoelectric element array of the present invention.

This laminar thermoelectric element 201 is constructed by laminating a p-type semiconductor layer 201c and an n-type semiconductor layer 201d, with an insulator layer 203 sandwiched between them.

The higher-temperature end 201a of the laminar thermoelectric element 201 comprises a P-N junction between the p- and n-type semiconductor layers 201c and 201d. In addition, plated electrodes 204 are formed on the top surface and the bottom surface of the lower-temperature end 201b of the laminar thermoelectric element 201 (the plated electrode on the bottom surface is not shown in the drawing), and a lead wire 205 is soldered to these plated electrodes 204.

The p-type semiconductor layer 201c constructing the laminar thermoelectric element 201 has a composition of, e.g., FeSi₂ doped with Cr, the n-type semiconductor layer 201d has a composition of, e.g., FeSi₂ doped with Co, and the insulator layer 203 has a composition of, e.g., a mixture of ZrO₂ and glass.

This laminar thermoelectric element 201 may be formed in the following manner, by way of example.

First, a solvent and a binder are added to and mixed with each of the above-mentioned compositions and adjusted to obtain the respective slurries which are made into green sheets (not shown) by a method using a doctor blade. The green sheets of the p-type semiconductor and the n-type semiconductor are cut into a predetermined size, and the green sheets of the insulator are cut into a predetermined size which is smaller than the size of the p-type semiconductor and the n-type semiconductor. In order to connect the cut green sheets of the p-type semiconductor and green sheets of the n-type semiconductor to each other alternately at the higher-temperature end 201a and the lower-temperature end 201b (see Fig. 9), a green sheet of the insulator is inserted in a green sheet of the p-type semiconductor and a green sheet of the n-type semiconductor to prepare a laminate of these green sheets which is then subjected to thermo-compression bonding.

The green laminate block obtained in this manner are cut into a predetermined size to obtain shapes. These shapes are degreased in the air, and then baked *in vacuo* without pressurization. On one end of each of the shapes after annealing operation which is intended to be used as the lower-temperature end, there is formed a plated electrode 204, as shown in Fig. 9, and a lead wire 205 is soldered to those plated electrodes 204. The laminar thermoelectric element 201 is formed in this way.

Fig. 10 is a perspective view of an embodiment of the thermoelectric element array of the present invention.

Here, 9 laminar thermoelectric elements 201 were used, in which each element was formed with six pairs of the p-type semiconductors and the n-type semiconductors, in the above-mentioned way, each 30 mm long, 6 mm wide and 5 mm thick. Each element produces an electromotive force of 1.5 V or more for a temperature difference of 600°C.

The higher temperature ends of these elements were fixed to a 0.6 mm-thick aluminum board with aluminum cement in a 3 x 3 matrix with pitches on the order of 5 mm. The respective elements 201 were connected electrically in series through soldered lead wires.

Uniform heating of the aluminum board 201 on a hot plate produced an electromotive force of 1.5 V for a temperature difference between the higher-temperature end and the lower-temperature end of 100°C. In the case of an array constructed with six π-type junction elements of the prior art and of the same area (see Fig. 2), the electromotive force is 0.3 V for 100°C, and this means that the product of the present invention provided a electromotive force five times that of the prior art product.

As explained above, according to the present invention, it is possible to readily obtain a higher-power thermoelectric element array than with a prior art material of the same size. In addition, since no metal junctions are needed at the higher-temperature end of the p-type semiconductor and the n-type semiconductor, the arrangement has a high degree of flexibility and thus a variety of needs are readily met.

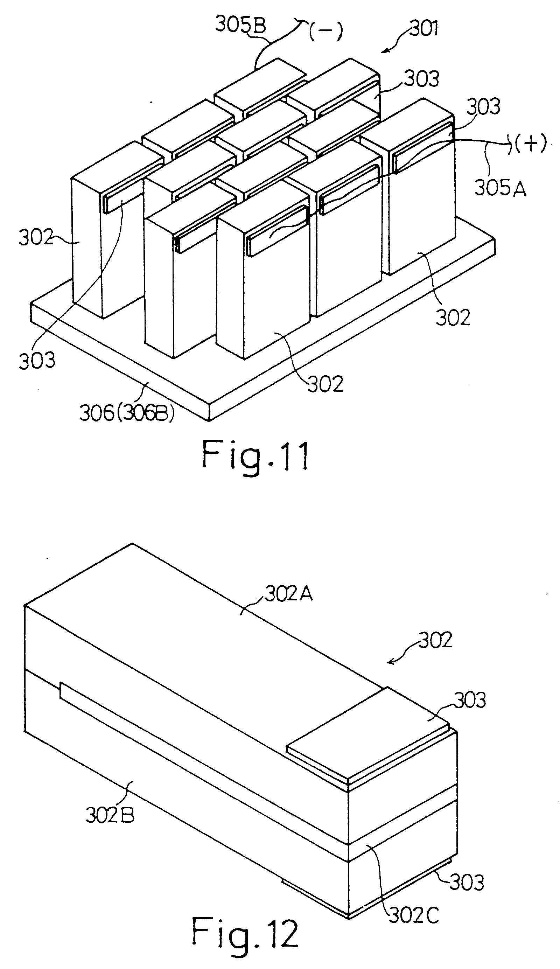

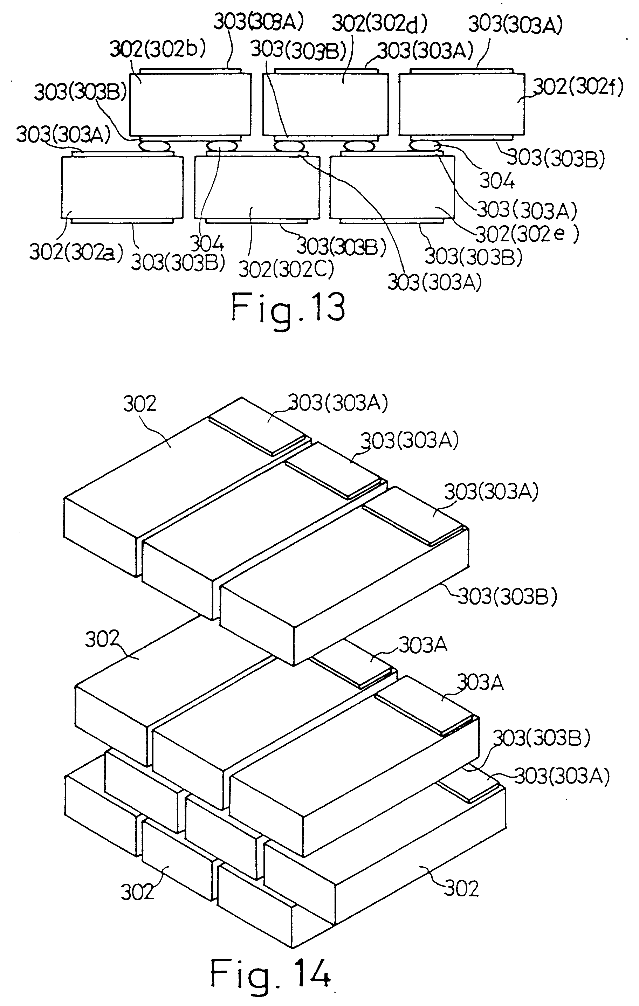

Fig. 11 is a perspective view illustrative of an embodiment of the thermoelectric element array of the present invention, Fig. 13 is a plan view of the main section thereof, Fig. 12 is a perspective view of a laminar thermoelectric element, and Fig. 14 is a perspective view illustrative of how the thermoelectric element array shown in Fig. 11 is assembled.

The thermoelectric element array 301 according to the present embodiment comprises twelve connected laminar thermoelectric elements 302 composed with one pair of the layers, which were manufactured by laminating and joining a p-type semiconductor 302A and an n-type semiconductor 302B, forming an insulating ceramic layer 302C between the layers except at the junction and forming terminal electrodes 303 and 303 on the outer surfaces, as shown in Fig. 12. The peripheries of the terminal electrodes 303 of the laminar thermoelectric element 302 are covered with the ceramic type heat-resistant coating agent KZ-1000 (manufactured by Taito Chemicals Co., Ltd.), and the terminal electrodes 303 are prepared by soldering plating onto nickel plating.

In order to assemble such thermoelectric element array 301, first, as shown in Fig. 14, three laminar thermoelectric elements 302 are horizontally placed in parallel, and laminated after the surfaces of the terminal electrodes 303 are coated with eutectic creamy solder 304 (shown in Fig. 13). Here, the arrangement is made in such a manner that the positive poles 303A and the negative poles 303B of the terminal electrodes are placed in parallel along the plane, respectively, and the positive poles 303A and the negative poles 303B are vertically connected to each other. With this arrangement, as shown in Fig. 13, the laminar thermoelectric elements are electrically connected to each other, along the route: positive pole 303A of the laminar thermoelectric element 302a → negative pole 303B of the laminar thermoelectric element 302b → positive pole 303A of the laminar thermoelectric element 302c → negative pole 303B of the laminar thermoelectric element 302d → positive pole 303A of the laminar thermoelectric element 302e → negative pole 303B of the laminar thermoelectric element 302f.

After the twelve laminar thermoelectric elements 302 were laminated, the resulting composite of the laminar thermoelectric elements is temporarily fixed with a metal clamping jig and then soldered firmly using a reflowing furnace. Thereafter, the electrodes 303 of the outermost laminar thermoelectric elements 302 of the composite of the laminar thermoelectric elements are connected through lead wires 305A and 305B. Then, the clamping jig is removed, the composite of the laminar thermoelectric elements is placed upright, and alumina boards 306 (306A, 306B) (the alumina board 306A on the top end surface not shown in Fig. 11) are bonded to the top and bottom end surfaces thereof. The thermoelectric element array 301 are prepared in this way.

Since this thermoelectric element array 301 need not have wiring between the laminar thermoelectric elements 302 and 302, the spacing between the laminar thermoelectric elements 302 and 302 can be reduced considerably compared to like elements of the prior art, and as a result, the area occupied by the thermoelectric element array can be substantially reduced.

For instance, as shown in Fig. 11, the thermoelectric element array of the twelve connected laminar thermoelectric elements has an area which is equal to 2/3 of the area of a prior art array, thus resulting in substantial space saving.

In addition, in the course of assembly of a thermoelectric element array of the present invention, the laminar thermoelectric elements may be stacked lying on their sides as shown in Fig. 14, as distinct from the prior art which requires rectangular laminar thermoelectric elements to be placed upright, and thus the assembly operation is rather easy as compared with the prior art.

Here, although the thermoelectric element array shown in the drawing is an array of twelve connected laminar thermoelectric elements each consisting of one pair of the layers, a laminate consisting of two or more pairs of the layers may be employed as the laminar thermoelectric element according to the present invention, and of course, there is no limit to the number of the laminar thermoelectric elements to be connected.

As detailed above, the thermoelectric element arrays of the present invention are high-voltage, high-power thermoelectric element arrays which comprise a plurality of connected laminar thermoelectric elements and results in space savings, and further are thermoelectric element arrays which have no danger of increasing resistance due to wiring and wire breakage, while also allowing added saving in space and being easy to assemble.

Accordingly, the thermoelectric element arrays provided by the present invention are high-reliability, compact, high-voltage, high-power and high-productivity thermoelectric element arrays.

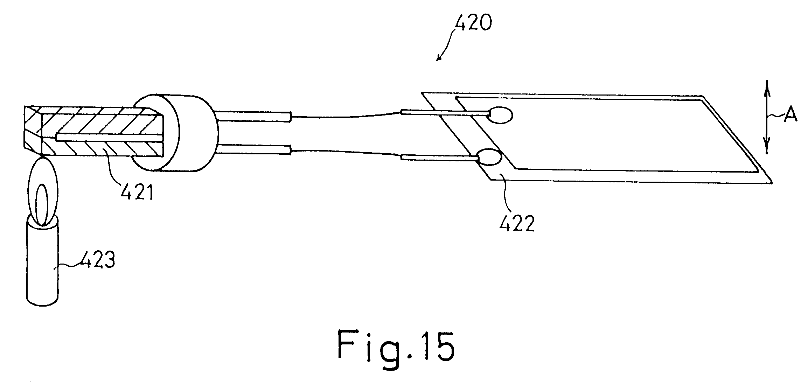

Fig. 15 is a schematic diagram illustrative of a thermal displacement converter of the present invention.

The thermal displacement converter 420 is equipped with a thermoelectric element 421 which develops a voltage in proportion to the difference in temperature between the higher-temperature end and the lower-temperature end and a piezoelectric unimorph 422 which is displaced in proportion to the voltage developed by the thermoelectric element 421, and the thermoelectric element 421 and the piezoelectric 422 are connected with attention to the polarities. It is also equipped with a volt meter (not shown) for measuring the voltage developed by the thermoelectric element 421 and an eddy-current type displacement meter (not shown) for measuring the amount of displacement of the tip of the piezoelectric unimorph 422. Here, the thermoelectric element 421 used was a FeSi₂-based element which developed a voltage of 0.3 V in cases where the above-mentioned temperature difference was 600°C at no load. In addition, a piezoelectric unimorph of the PZT type which was displaced 500 µm at an applied voltage of 200 V was used as the piezoelectric unimorph 422.

An experiment using the above-described thermal displacement converter 420 will now be explained with additional reference to Fig. 15.

In cases where the tip of the thermoelectric element 421 is heated with a burner 423, a voltage of 0.2 V at the maximum was developed across the thermoelectric element 421, upon which the tip of the piezoelectric unimorph 422 was displaced 0.5 µm in the direction of displacement indicated by the arrow A. Further, in cases where the voltage of the thermoelectric element 421 was increased to a maximum of 40 V by amplification through a 200-fold-gain amplifier, the tip of the piezoelectric unimorph 422 was displaced 100 µm Furthermore, in cases where the temperature of the tip of the thermoelectric element 421 was adjusted by changing the distance between the thermoelectric element 421 and the burner 423, the amount of displacement of the piezoelectric unimorph 422 changed depending on the temperature, and the piezoelectric unimorph 422 returned to its initial point (zero point) when the burner 423 was turned off.

As explained above, the thermal displacement converter 420 according to the present embodiment has a simpler configuration as compared with prior art thermal displacement converters, and, even if the voltage developed by the thermoelectric element 421 is low, can drive the piezoelectric unimorph 422 proportional to the voltage.

In cases where the voltage developed by the thermoelectric element is lower as compared with the driving voltage of the piezoelectric actuator, it is advisable to provide the thermal displacement converter with a voltage amplifier circuit which amplifies the voltage developed by the thermoelectric element. Even in cases where the voltage amplification circuit is provided, thermal displacement converters of the present invention are simpler apparatuses as compared with thermal displacement converters of the prior art.

As explained above, thermal displacement converters of the present invention are equipped with a thermoelectric element formed with a thermoelectric material and a piezoelectric actuator which is displaced proportional to the voltage developed by the thermoelectric element, and therefore are simpler apparatuses as compared with thermal displacement converters of the prior art.

## Claims

1. A thermoelectric element characterized by comprising:
a P-type semiconductor and an N-type semiconductor placed facing each other, with a P-N junction at one end thereof;
a first insulator which is formed between the facing surfaces of said P-type semiconductor and said N-type semiconductor to insulate said P-type semiconductor and said N-type semiconductor from each other;
second insulating materials formed on the respective surfaces opposite the facing surfaces; and
said P-type semiconductor, said N-type semiconductor, said first insulator and said second insulating materials being baked integrally.

2. A thermoelectric element characterized by comprising:
a plurality of P-type semiconductors and a plurality of N-type semiconductors placed facing each other and alternately, with P-N junctions at either alternating end thereof;
a first insulator which is formed between each of the facing surfaces of said P-type semiconductors and said N-type semiconductors to insulate said P-type semiconductors and said N-type semiconductors from each other;
second insulating materials formed on the respective surfaces opposite the facing surfaces of the outermost ones of said P-type semiconductors and said N-type semiconductors; and
said P-type semiconductors, said N-type semiconductors, said first insulators and said second insulating materials being baked integrally.

3. A thermoelectric element characterized by comprising:
a laminate of alternating p-type semiconductors and n-type semiconductors, with junctions formed at said laminar interfaces for establishing electric connections between the p-type semiconductors and the n-type semiconductors and with intervening insulating layers present in regions other than the junctions of said laminar interfaces; and
said insulating layers being sintered materials of a mixture comprising one or more insulator ceramics selected from the group consisting of zirconium oxide, aluminum oxide, magnesium oxide, titanium oxide and yttrium oxide, and glass, the content of said glass being 10-50% by weight.

4. A thermoelectric element as claimed in Claim 3, wherein the glass contained in the mixture comprises silicon oxide, boron oxide, aluminum oxide and an alkaline earth metal oxide.

5. A thermoelectric element array characterized by comprising a plurality of electrically connected, laminar thermoelectric elements which comprise one or more laminated pairs of a P-type semiconductor and an N-type semiconductor, with a P-N junction at the higher-temperature end and an intervening insulating layer at the lower-temperature end thereof, and are placed with the higher-temperature ends on an identical plane.

6. A thermoelectric element array comprising a plurality of connected laminar thermoelectric elements,
characterized in that a terminal electrode formed on the outer surface of each of said laminar thermoelectric elements is directly connected with a terminal electrode formed on the outer surface of another of said laminar thermoelectric elements adjacent to the former laminar thermoelectric element to electrically connect the two laminar thermoelectric elements.

7. A thermal displacement converter characterized by comprising:
a thermoelectric element which is formed of a thermoelectric material and develops a voltage proportional to a temperature; and
a piezoelectric actuator which is displaced due to the voltage developed by said thermoelectric element and proportional to said voltage.
